# EUROPEAN PATENT SPECIFICATION

(11) **EP 2 230 892 B1**
(45) Date of publication and mention of the grant of the patent: **05.12.2012**
(21) Application number: 09290199.0
(22) Date of filing: 18.03.2009
(51) Int. Cl.: H05K 9/00, H05K 3/34

(54) **Electro-magnetic sealing with solder bump array gasket on printed circuit board**
Elektromagnetische Dichtung mit Löthöckeranordnungsdichtung auf einer Druckleiterplatte
Scellage électromagnétique avec un joint à réseau de bossages de soudure sur une carte de circuit imprimé

(43) Date of publication of application: 22.09.2010
(73) Proprietor: Alcatel Lucent, 75007 Paris (FR)
(72) Inventor: Thomas, Kevin, Tetbury, Glos GL88DY (GB)
(74) Representative: Anderlini, Alain

(56) References cited:
- EP-A1- 0 986 293
- DE-A1- 10 228 981
- GB-A- 2 378 042
- US-B1- 6 462 436

## Description

The present invention relates to an electromagnetic shielding assembly comprising a printed circuit board as well as an upper housing with at least one first wall of which a conductive bottom part is adapted to be brought into contact with a first conductive track on a first side of said printed circuit board, and a lower housing with at least a second wall of which a conductive bottom part is adapted to be brought into contact with a second conductive track on a second side of said printed circuit board, said second side being opposite to said first side of said printed circuit board, said electromagnetic shielding assembly further comprises a first plurality of solder bumps provided on said first conductive track, and comprises a second plurality of solder bumps provided on said second conductive track of said printed circuit board.

Such an electromagnetic shielding assembly generally comprises a conductive elastomeric gasket dispensed onto one or more walls which are located between circuits on a radio board. The sealing, or at least a part thereof, conducts electrically to allow having a same potential on the conductive track of the printed circuit board as on the bottom part, and possibly also on the wall, of the electromagnetic shielding assembly.

Moreover, the electromagnetic shielding assembly preferably not only conducts electrically, but also has good thermal conductivity to permit efficient heat transfer from the circuits to a possible housing and/or heatsink.

However, this known electromagnetic shielding assembly is relatively expensive, as the gasket material itself is expensive (it is often silver loaded, and it is a very custom application), and dispensing it in very controlled dimensions (both width and height) onto a wall is not cheap. Furthermore, although the elastomeric gasket has good electrical conductivity, it does not have good thermal conductivity.

It would be possible to use a pre-shaped or cut metal foil gasket instead of the elastomeric gasket, but this form of gasket would be another piece part in the assembly with an associated cost.

The cost is likely to be reasonably high as the wall and the shapes of the conductive track on the printed circuit board corresponding to the bottom part of this wall shapes will be custom, and a lot of material will be wasted in making custom shaped metal foil gaskets. Making sure that the gasket aligns properly with the circuits and the wall during assembly would present other risks and associated costs.

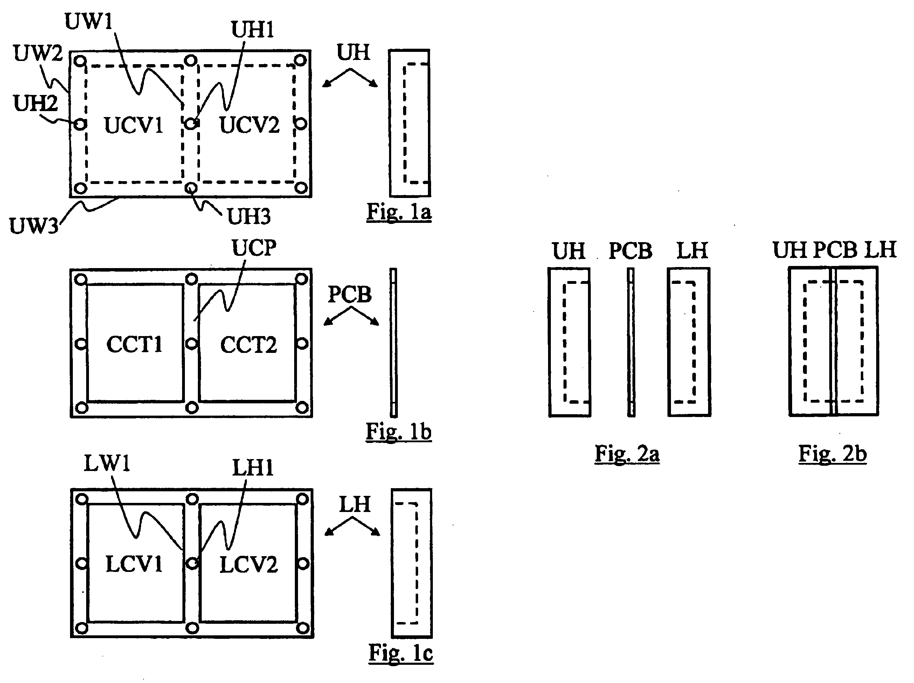

A known sealing is represented at Figs. 1a to 1c and 2a to 2b and comprises an upper metal housing UH and a lower metal housing LH, of which top views are respectively shown at the Figs. 1 a and 1 c. The Fig. 1b shows the printed circuit board PCB with conductive tracks as UCP on the printed circuit board PCB delimiting the circuits CCT1 and CCT2. The housing UH has walls such as UW1, UW2, UW3 and an upper part so as to form cavities UCV1 and UCV2 as shown, whilst the housing LH has walls such as LW1 and a lower part so as to form cavities LCV1 and LCV2 as shown. The bottom parts of the walls of the cavities UCV1 and UCV2 match with the conductive tracks as UCP delimiting the circuits CCT1 and CCT2 on one side of the printed circuit board PCB. The bottom parts of the walls of the cavities LCV1 and LCV2 match with the conductive tracks on the other side of the printed circuit board PCB.

A sided view of the assembly, prior to be brought into contact, is shown at Fig. 2a, whilst the completed assembly is shown at Fig. 2b. This conventional assembly provides electro-magnetic isolation between the circuits CCT1 and CCT2.

The known embodiment for electromagnetic shielding assembly uses a conductive elastomeric gasket, dispensed onto the walls of the housings, separating the circuits CCT1 and CCT2 into individual cavities as UCV1 and UCV2 and LCV1 and LCV2.

This embodiment works well as an electro-magnetic seal, reducing electro-magnetic interference and improving electro-magnetic compatibility.

However, as already mentioned, it is requires expensive gasket material of which the dispensing onto the housing walls is also not cheap. Moreover, it does not have good thermal conductivity.

When an array of solder bumps is provided onto the printed circuit board, as part of normal printed circuit board manufacture, the latter array acts as a cheap electrically conductive gasket, isolates circuits from each other, and acts as a thermally conductive gasket to improve the heat transfer from the circuits to their housings.

The solder array is much more thermally conductive than the elastomeric gasket. The solder material is cheaper than the elastomer, and because it is dispensed during the surface mount assembly process, the precision of the placement is just part of the normal board assembly process, it doesn't require the housings to go to special gasket dispensing machines.

As the solder array is manufactured during normal surface mount assembly, it is precision aligned with the circuits, so there is no risk of a separate foil gasket misaligning and shorting the circuits out, or folding under the housing walls to create uneven gaps. It doesn't require a separate manufacturing step, i.e. placement of a separate foil gasket.

An object of the present invention is to provide an electromagnetic shielding assembly having both high electrical and thermal conductivity, but with an even lower manufacturing cost.

According to the invention, this object is achieved due to the fact that said upper housing is adapted to be fixed to said lower housing by means of a screw engaged through a hole into said first wall, through said printed circuit board, and in a threaded hole into said second wall.

In this way, by using a screw to compress the solder bumps, the assembly can be taken apart easily and without applying extra heat.

Furthermore, when compressed, the solder bumps still provide a cheap electrically and thermally conductive electromagnetic shielding assembly for circuits on a printed circuit board.

It is to be noted that the following documents also disclose an electromagnetic shielding assembly for circuits on a printed circuit board:
- Patent Application DE 102 28 981 Al (AUTOMOTIVE LIGHTING REUTLINGEN [DE]) published on 15 January 2004. This known document discloses that the solder on the printed circuit board is melted to fix the electromagnetic shielding assembly. In this way the mechanical part of the electromagnetic shielding assembly is permanently fixed to the printed board, unless it is de-soldered, which is usually quite a labor intensive process;
- Patent Application GB 2 378 042 A (UBINETICS LTD [GB]) published on 29 January 2003. Also this known document discloses that the solder on the printed circuit board is melted to fix the electromagnetic shielding assembly, with the drawback mentioned above; and
- Patent US 6 462 436 B1 (KAY JASON A [US] ET AL) published on 8 October 2002. Therein is disclosed that a housing edge is used to bite into a solder trace or bead on the board.

More generally, all these known documents disclose an electromagnetic shielding assembly that is soldered on the printed circuit board, while the present invention just uses screws to compress solder balls. In this way, the assembly can be taken apart easily and without applying extra heat, whereby a cheap and removable electromagnetic shielding assembly is obtained.

Another characterizing embodiment of the present invention is that the conductive bottom part of said wall is adapted to be compressed onto said solder bumps.

The size and shape and spacing of the solder bumps can be varied as necessary to achieve the right amount of electrical isolation and thermal conduction.

Still another characterizing embodiment of the present invention is that said printed circuit board is provided with vias adapted to interconnect the first and the second conductive track of said printed circuit board.

Also another characterizing embodiment of the present invention is that the solder bumps of said first plurality are adapted to be connected to the solder bumps of said second plurality through said vias of said printed circuit board.

The solder bumps of the two arrays or pluralities being so interconnected.

Another characterizing embodiment of the present invention is that said solder bumps are disposed in an array and are adapted to be reflowed to form a conductive field.

The solder bump array allows a contact to be achieved with the bottom part of the wall.

Further characterizing embodiments of the present electromagnetic shielding assembly are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:
Figs. 1a - 1c are top and side views of items of a conventional electromagnetic shielding assembly;
Figs. 2a and 2b are side views of the conventional electromagnetic shielding assembly of the Fig. 1a - 1c before and after their assembly;
Fig. 3 shows an electromagnetic shielding assembly comprising solder bumps according to the invention; and
Figs. 4 and 5 are examples of arrays of solder bumps belonging to the electromagnetic shielding assembly of the invention.

The electromagnetic shielding assembly of the present invention is based on a conventional electro-magnetic sealing as represented at the Figs. 1a to 1c, 2a, 2b and 3.

The electromagnetic shielding assembly comprises an upper housing UH and a lower housing LH of which the walls, e.g. UW1, UW2, UW3 and LW1, have conductive bottom parts to be brought into contact with at least one conductive track UCP on a printed circuit board PCB. Each wall has at least one side that is conductive and in contact with the conductive bottom part of the wall. The walls are therefore either coated with a conductive layer or are of metal or of another material to be electrically and thermally conductive towards the conductive track UCP of the printed circuit board PCB.

On the one hand, the conductive track UCP on the printed circuit board PCB delimits circuits CCT1 and CCT2. On the other hand, the walls UW1, UW2, UW3 and an upper part of the upper housing UH form cavities UCV1 and UCV2, whilst the walls LW1 and a lower part of the lower housing LH form cavities LCV1 and LCV2. The bottom parts of the walls UW1, UW2, UW3 of the cavities UCV1 and UCV2 match with the conductive track UCP on the upper side of the printed circuit board PCB delimiting the circuits CCT1 and CCT2. The bottom parts of the walls, e.g. LW1, of the cavities LCV1 and LCV2 match with a conductive track on the opposite or lower side of the printed circuit board PCB. In this example, the design of the conductive track UCP on the upper side of the printed circuit board PCB corresponds to the design of the conductive track on the lower side of this printed circuit board PCB.

A side view of the electromagnetic shielding assembly of the housings UH and LH, prior to be brought into contact with the printed circuit PCB, is shown at Fig. 2a, whilst the assembly completed is shown at Fig. 2b. This assembly provides electro-magnetic isolation between the circuits CCT1 and CCT2.

A possible embodiment for electromagnetic shielding assembly uses a conductive elastomeric gasket, dispensed onto the walls of the housings UH and LH, separating the circuits CCT1 and CCT2 into individual cavities.

The walls UW1, UW2, UW3 of the upper housing UH are fixed to the walls LW1 of the lower housing LH by means of screws engaged in holes UH1, UH2, UH3, LH1 of these housings and through corresponding holes of the printed circuit board PCB. The holes LH1 of the lower housing LH are for instance threaded blind holes wherein the screws are fixed.

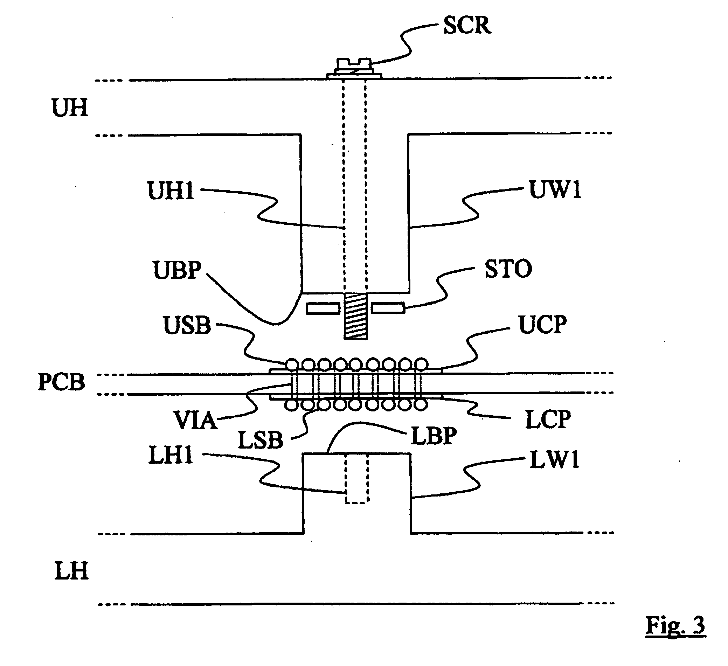

Although such an embodiment works well as an electro-magnetic seal, reducing electro-magnetic interference, its electrical and thermal conductivity may be improved by providing an array of solder bumps USB on the conductive track UCP of the printed circuit board PCB, as shown at Fig. 3.

In a preferred embodiment, a second array of solder bumps LSB is also provided on the conductive track LCP of the printed circuit board PCB.

Owing to the screw SCR, engaged in the hole UH1 of the wall UW1 of the upper housing UH , a hole (not visible at Fig. 3) of the printed circuit board PCB and screwed in the threaded blind hole LH1 of the wall LW1 of the lower housing LH, the conductive bottom part UBP of the wall UW1 is compressed onto the upper array of solder bumps USB on the conductive track UCP and the conductive bottom part LBP of the wall LW1 is compressed onto the lower array of solder bumps LSB on the conductive track LCP on the opposite side of the printed circuit board PCB.

In a variant embodiment, the printed circuit board PCB is provided with vias VIA interconnecting the upper conductive track UCP with the lower conductive track LCP. Owing to these vias VIA, the solder bumps USB on the upper conductive track UCP are connected to the solder bumps LSB of the lower conductive track LCP.

The arrays of solder bumps USB and LSB printed onto the printed circuit board PCB are part of normal printed circuit board manufacturing. These arrays act as a cheap electrically conductive gasket, to isolate circuits from each other, and act as a thermally conductive gasket to improve the heat transfer from the circuits to their housings.

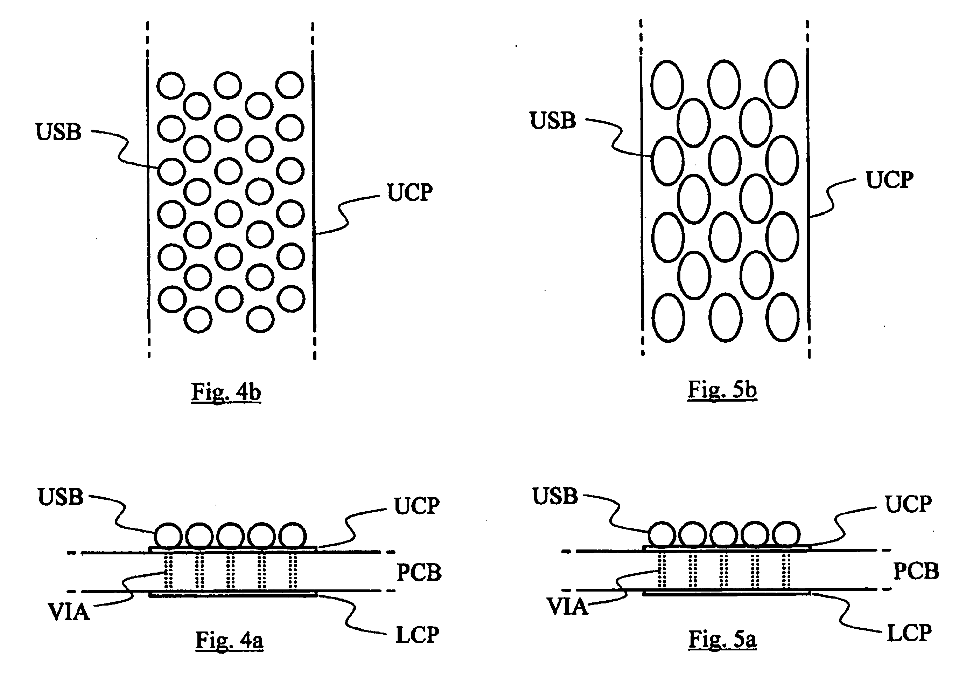

An array of solder balls, as shown at Fig. 4a, or bumps, as shown at Fig. 4b, is printed onto the printed circuit board PCB during normal surface mount component assembly. When the circuit is loaded with components and it is reflowed the solder arrays form as fields of solder bumps. The arrays are printed in the shape of the walls of the housing so that the housing is divided into individual cavities. The circuits in the cavities are electro-magnetically isolated from each other when the housing is compressed onto the solder arrays.

The size, shape and spacing of the solder bumps USB can be varied as necessary to achieve the right amount of electrical isolation and thermal conduction.

Solder bumps are used because they provide an level surface for contact (a large pool of solder wouldn't necessarily reflow to a constant height over a large area), and the bumps act as contact points to ensure that a good connection is made between the housing and the circuit.

As shown at Fig. 3, a stand-off STO may be inserted between the housing walls UW1 and the printed circuit board PCB to govern the amount of compression on the solder ball array USB. If the housing UH is removed many times, and the solder becomes too compressed to contact the housing in an efficient way, then a thinner stand-off may be inserted.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. An electromagnetic shielding assembly comprising a printed circuit board (PCB) as well as
an upper housing (UH) with at least one first wall (UW1) of which a conductive bottom part (UBP) is adapted to be brought into contact with a first conductive track (UCP) on a first side of said printed circuit board (PCB),
and a lower housing (LH) with at least a second wall (LW1) of which a conductive bottom part (LBP) is adapted to be brought into contact with a second conductive track (LCP) on a second side of said printed circuit board, said second side being opposite to said first side of said printed circuit board,
said electromagnetic shielding assembly further comprises a first plurality of solder bumps (USB) provided on said first conductive track (UCP),
and comprises a second plurality of solder bumps (LSB) provided on said second conductive track (LCP) of said printed circuit board,
***characterized in that*** said upper housing (UH) is adapted to be fixed to said lower housing (LH) by means of a screw (SCR) engaged through a hole (UH1) into said first wall (UW1) through said printed circuit board (PCB), and in a threaded hole (LH1) into said second wall (LW1) and,
***in that*** the conductive bottom part (UBP; LBP) of said walls (UW1; LW1) are adapted to be compressed onto said solder bumps (USB; LSB) for providing an electromagnetic sealing.

2. The electromagnetic shielding assembly according to claim 1, ***characterized in that*** said electromagnetic shielding assembly further comprises a stand-off (STO) adapted to be engaged onto said screw (SCR) and inserted between the conductive bottom part (UBP) of a wall (UW1) and a conductive track (UCP) of the printed circuit board (PCB).

3. The electromagnetic shielding assembly according to claim 1, ***characterized in that*** said printed circuit board is provided with vias (VIA) adapted to interconnect the first (UCP) and the second (LCP) conductive track of said printed circuit board (PCB).

4. The electromagnetic shielding assembly according to claim 3, ***characterized in that*** the solder bumps (USB) of said first plurality are adapted to be connected to the solder bumps (LSB) of said second plurality through said vias (VIA) of said printed circuit board (PCB).

5. The electromagnetic shielding assembly according to claim 1, ***characterized in that*** said solder bumps (USB; LSB) are disposed in an array and are adapted to be reflowed to form a conductive field.

6. The electromagnetic shielding assembly according to claim 1, ***characterized in that*** said wall (UW1; LW1) is thermally conductive.

7. The electromagnetic shielding assembly according to claim 1, ***characterized in that*** at least one side of said first (UW1) and/or second (LW1) wall is conductive and in contact with the conductive bottom part (UBP; LBP) of said wall.

8. The electromagnetic shielding assembly according to claim 1, ***characterized in that*** said first (UW1) and/or second (LW1) wall is coated with a conductive layer in contact with the conductive bottom (UBP; LBP) part of said wall.

9. The electromagnetic shielding assembly according to claim 1, ***characterized in that*** said first (UW1) and/or second (LW1) wall is electrically conductive.

10. The electromagnetic shielding assembly according to claim 1, ***characterized in that*** said electromagnetic shielding assembly is provided with several walls (UW1-3) delimiting a cavity (UCV1).

11. The electromagnetic shielding assembly according to claim 10, ***characterized in that*** each wall (UW1-3) of said cavity (UCV1) has a conductive bottom part (UBP) adapted to be brought into contact with a conductive track (UCP) of said printed circuit board (PCB).

## Patentansprüche

1. Elektromagnetische Abschirmungsanordnung, umfassend eine Druckleiterplatte (PCB) sowie
ein oberes Gehäuse (UH) mit mindestens einer ersten Wand (UW1), deren leitfähiger unterer Teil (UBP) dazu bestimmt ist, mit einer ersten Leiterbahn (UCP) auf einer ersten Seite der besagten Druckleiterplatte (PCB) in Kontakt gebracht zu werden,
und ein unteres Gehäuse (LH) mit mindestens einer zweiten Wand (LW1), deren leitfähiger unterer Teil (LBP) dazu bestimmt ist, mit einer zweiten Leiterbahn (LCP) auf einer zweiten Seite der besagten Druckleiterplatte in Kontakt gebracht zu werden, wobei die besagte zweite Seite der besagten ersten Seite der besagten Druckleiterplatte gegenüberliegt,
wobei die besagte elektromagnetische Abschirmungsanordnung weiterhin eine erste Vielzahl von Löthöckern (USB) umfasst, welche auf der besagten ersten Leiterbahn (UCP) angeordnet sind,
und eine zweite Vielzahl von Löthöckern (LSB) umfasst, welche auf der besagten zweiten Leiterbahn (LCP) der besagten Druckleiterplatte angeordnet sind,
***dadurch gekennzeichnet, dass*** das besagte obere Gehäuse (UH) dazu bestimmt ist, anhand einer durch ein Loch (UH1) in die besagte erste Wand (UW1), durch die besagte Druckleiterplatte (PCB) und in ein Gewindeloch (LH1) in die besagte zweite Wand (LW1) eingeführten Schraube an dem besagten unteren Gehäuse (LH) befestigt zu werden, und
*dass* die leitfähigen unteren Teile (UBP; LBP) der besagten Wände (UW1; LW1) dazu bestimmt sind, auf die besagten Löthöcker (USB; LSB) gepresst zu werden, um eine elektromagnetische Abdichtung zu gewährleisten.

2. Elektromagnetische Abschirmungsanordnung nach Anspruch 1, ***dadurch gekennzeichnet, dass*** die besagte elektromagnetische Abschirmungsanordnung weiterhin ein Abstandselement (STO) umfasst, welches dazu bestimmt ist, in die besagte Schraube (SCR) einzugreifen und zwischen dem leitfähigen unteren Teil (UBP) einer Wand (UW1) und einer Leiterbahn (UCP) der Druckschaltung (PCB) eingefügt zu werden.

3. Elektromagnetische Abschirmungsanordnung nach Anspruch 1, ***dadurch gekennzeichnet, dass*** die besagte Druckleiterplatte mit Bohrungen (VIA) versehen ist, die dazu bestimmt sind, die erste (UCP) und die zweite (LCP) Leiterbahn der besagten Druckleiterplatte (PCB) miteinander zu verbinden.

4. Elektromagnetische Abschirmungsanordnung nach Anspruch 3, ***dadurch gekennzeichnet, dass*** die Löthöcker (USB) der besagten ersten Vielzahl dazu bestimmt sind, durch die besagten Bohrungen (VIA) der besagten Druckleiterplatte (PCB) hindurch mit den Löthöckern (LSB) der besagten zweiten Vielzahl verbunden zu werden.

5. Elektromagnetische Abschirmungsanordnung nach Anspruch 1, ***dadurch gekennzeichnet, dass*** die besagten Löthöcker (USB; LSB) in einer Anordnung angelegt und dazu bestimmt sind, aufgeschmolzen zu werden, um ein leitfähiges Feld zu bilden.

6. Elektromagnetische Abschirmungsanordnung nach Anspruch 1, ***dadurch gekennzeichnet, dass*** die besagte Wand (UW1; LW1) wärmeleitfähig ist.

7. Elektromagnetische Abschirmungsanordnung nach Anspruch 1, ***dadurch gekennzeichnet, dass*** mindestens eine Seite der besagten ersten (UW1) und/oder der besagten zweiten (LW1) Wand leitfähig ist und mit dem leitfähigen unteren Teil (UBP; LBP) der besagten Wand in Kontakt steht.

8. Elektromagnetische Abschirmungsanordnung nach Anspruch 1, ***dadurch gekennzeichnet, dass*** die besagte erste (UW1) und/oder die besagte zweite (LW1) Wand mit einer leitfähigen Schicht, welche mit dem leitfähigen unteren (UBP; LBP) Teil der besagten Wand in Kontakt steht, überzogen sind.

9. Elektromagnetische Abschirmungsanordnung nach Anspruch 1, ***dadurch gekennzeichnet, dass*** die besagte erste (UW1) und/oder die besagte zweite (LW1) Wand elektrisch leitfähig sind.

10. Elektromagnetische Abschirmungsanordnung nach Anspruch 1, ***dadurch gekennzeichnet, dass*** die besagte elektromagnetische Abschirmungsanordnung mit mehreren Wänden (UW1-3), welche einen Hohlraum (UCV1) abgrenzen, versehen ist.

11. Elektromagnetische Abschirmungsanordnung nach Anspruch 1, ***dadurch gekennzeichnet, dass*** jede Wand (UW1-3) des besagten Hohlraums (UCV1) einen leitfähigen unteren Teil (UBP) aufweist, der dazu bestimmt ist, mit einer Leiterbahn (UCP) der besagten Druckleiterplatte (PCB) in Kontakt gebracht zu werden.

## Revendications

1. Assemblage de protection électromagnétique comprenant une carte de circuit imprimé (PCB) ainsi que
un boîtier supérieur (UH) avec au moins une première paroi (UW1) dont une partie inférieure conductrice (UBP) est adaptée pour venir au contact d'une première piste conductrice (UCP) sur un premier côté de ladite carte de circuit imprimé (PCB),
et un boîtier inférieur (LH) avec au moins une deuxième paroi (LW1) dont une partie inférieure conductrice (LBP) est adaptée pour venir au contact d'une deuxième piste conductrice (LCP) sur un deuxième côté de ladite carte de circuit imprimé, ledit deuxième côté étant opposé audit premier côté de ladite carte de circuit imprimé,
ledit assemblage de protection électromagnétique comprend en outre une première pluralité de perles de soudure (USB) prévues sur ladite première piste conductrice (UCP),
et comprend une deuxième pluralité de perles de soudure (LSB) prévues sur ladite deuxième piste conductrice (LCP) de ladite carte de circuit imprimé,
***caractérisé en ce que*** ledit boîtier supérieur (UH) est adapté pour être fixé audit boîtier inférieur (LH) au moyen d'une vis (SCR) engagée dans un orifice (UH1) dans ladite première paroi (UW1), à travers ladite carte de circuit imprimé (PCB), et dans un orifice fileté (LH1) dans ladite deuxième paroi (LW1) et,
***en ce que*** la partie inférieure conductrice (UBP ; LBP) desdites parois (UW1 ; LW1) est adaptée pour être comprimée sur lesdites perles de soudure (USB; LSB) pour fournir un scellage électromagnétique.

2. Assemblage de protection électromagnétique selon la revendication 1, ***caractérisé en ce que*** ledit assemblage de protection électromagnétique comprend en outre un élément d'écartement (STO) adapté pour être engagé sur ladite vis (SCR) et inséré entre la partie inférieure conductrice (UBP) d'une paroi (UW1) et une piste conductrice (UCP) de la carte de circuit imprimé (PCB).

3. Assemblage de protection électromagnétique selon la revendication 1, ***caractérisé en ce que*** ladite carte de circuit imprimé est dotée de traversées (VIA) adaptées pour interconnecter la première piste conductrice (UCP) et la deuxième piste conductrice (LCP) de ladite carte de circuit imprimé (PCB).

4. Assemblage de protection électromagnétique selon la revendication 3, ***caractérisé en ce que*** les perles de soudure (USB) de ladite première pluralité sont adaptées pour être connectées aux perles de soudure (LSB) de ladite deuxième pluralité par l'intermédiaire desdites traversées (VIA) de ladite carte de circuit imprimé (PCB).

5. Assemblage de protection électromagnétique selon la revendication 1, ***caractérisé en ce que*** lesdites perles de soudure (USB ; LSB) sont disposées dans un réseau et sont adaptées pour subir une refusion afin de former un champ conducteur.

6. Assemblage de protection électromagnétique selon la revendication 1, ***caractérisé en ce que*** ladite paroi (UW1 ; LW1) est thermiquement conductrice.

7. Assemblage de protection électromagnétique selon la revendication 1, ***caractérisé en ce qu'***au moins un côté de ladite première paroi (UW1) et/ou de ladite deuxième paroi (LW1) est conducteur et au contact de la partie inférieure conductrice (UBP ; LBP) de ladite paroi.

8. Assemblage de protection électromagnétique selon la revendication 1, ***caractérisé en ce que*** ladite première paroi (UW1) et/ou ladite deuxième paroi (LW1) est revêtue d'une couche conductrice en contact avec la partie inférieure conductrice (UBP ; LBP) de ladite paroi.

9. Assemblage de protection électromagnétique selon la revendication 1, ***caractérisé en ce que*** ladite première paroi (UW1) et/ou ladite deuxième paroi (LW1) est électriquement conductrice.

10. Assemblage de protection électromagnétique selon la revendication 1, ***caractérisé en ce que*** ledit assemblage de protection électromagnétique est doté de plusieurs parois (UW1-3) délimitant une cavité (UCV1).

11. Assemblage de protection électromagnétique selon la revendication 11, ***caractérisé en ce que*** chaque paroi (UW1-3) de ladite cavité (UCV1) présente une partie inférieure conductrice (UBP) adaptée pour venir au contact d'une piste conductrice (UCP) de ladite carte de circuit imprimé (PCB).
